# EUROPEAN PATENT APPLICATION

(11) **EP 4 343 818 A1**
(43) Date of publication of application: **27.03.2024**
(21) Application number: 22804592.8
(22) Date of filing: 12.05.2022
(51) Int. Cl.: H01L 21/304

(54) **SUBSTRATE TREATMENT METHOD AND SUBSTRATE TREATMENT DEVICE**

(30) Priority: 17.05.2021 JP 2021083171
(71) Applicant: SCREEN Holdings Co., Ltd., Kyoto-shi, Kyoto 602-8585 (JP)
(72) Inventor: MAGARA Keiji, Kyoto-shi, Kyoto 602-8585 (JP)
(74) Representative: Kilian Kilian & Partner mbB
(86) International application number: PCT/JP2022/020091
(87) International publication number: WO 2022/244679

(57) **Abstract**

Provided is a technique capable of suppressing collapse of a three-dimensional structure. A substrate processing method includes a phosphoric acid processing step (S13), a coarse rinse processing step (S15), and a single-substrate drying processing step (S23). In the phosphoric acid processing step (S13), a plurality of substrates are immersed in phosphoric acid inside a processing tank. In the coarse rinse processing step (S15), after the phosphoric acid processing step (S13), a part of the phosphoric acid adhering to the plurality of substrates is replaced with a first rinse liquid to an extent that the phosphoric acid remains in patterns of the plurality of substrates. In the single-substrate drying processing step (S23), the plurality of substrates are dried one by one after the coarse rinse processing step (S15).

## Description

### TECHNICAL FIELD

The present disclosure relates to a substrate processing method and a substrate processing apparatus.

### BACKGROUND ART

Conventionally, a batch-type processing apparatus has been proposed that etches and removes a silicon nitride film by using phosphoric acid. Since the batch-type processing apparatus collectively processes a plurality of substrates, the apparatus can process the substrates with a high throughput. The processing apparatus performs rinse processing for replacing phosphoric acid adhered to the plurality of substrates with a rinse liquid. Then, the processing apparatus performs drying processing for collectively drying the plurality of substrates after the rinse processing.

Note that Patent Documents 1 and 2 are presented as techniques related to the present application.

### PRIOR ART DOCUMENT

### PATENT DOCUMENTS

Patent Document 1: Japanese Unexamined Patent Application Publication (Translation of PCT Application) No. 2016-502275
Patent Document 2: Japanese Patent Application Laid-Open No. 2020-141063

### SUMMARY

### PROBLEM TO BE SOLVED BY THE INVENTION

However, in recent years, a three-dimensional structure (for example, a pattern) to be formed on a substrate becomes fine, and when a plurality of substrates are collectively subjected to the drying processing, the three-dimensional structure may collapse.

Therefore, the present disclosure aims at providing a technique capable of suppressing the collapse of the three-dimensional structure.

### MEANS TO SOLVE THE PROBLEM

A first aspect of a substrate processing method includes: a phosphoric acid processing step of immersing a plurality of substrates in phosphoric acid inside a processing tank; a coarse rinse processing step of replacing a part of the phosphoric acid adhering to the plurality of substrates with a first rinse liquid to an extent that the phosphoric acid remains in patterns of the plurality of substrates after the phosphoric acid processing step; and a single-substrate drying processing step of drying the plurality of substrates one by one after the coarse rinse processing step.

A second aspect of the substrate processing method is the substrate processing method according to the first aspect, in which the coarse rinse processing step ends in a state where a concentration of the phosphoric acid in the patterns is 50% or more.

A third aspect of the substrate processing method is the substrate processing method according to the first or second aspect, in which the coarse rinse processing step includes a temperature reduction step of reducing a temperature of the first rinse liquid.

A fourth aspect of the substrate processing method is the substrate processing method according to any one of the first to third aspects, which further includes a coarse drying processing step of removing at least a part of a liquid adhering to out-of-pattern regions of the plurality of substrates without the patterns formed thereon between the coarse rinse processing step and the single-substrate drying processing step.

A fifth aspect of the substrate processing method is the substrate processing method according to the fourth aspect, in which in the coarse drying processing step, the plurality of substrates are exposed to an atmosphere of steam of a second rinse liquid having latent heat of vaporization lower than that of the first rinse liquid.

A sixth aspect of the substrate processing method is the substrate processing method according to any one of the first to fifth aspects, in which the phosphoric acid processing step includes: a step of lowering the plurality of substrates to immerse the plurality of substrates in the phosphoric acid inside the processing tank; and a step of raising the plurality of substrates at a first rising speed to pull up the plurality of substrates from the processing tank, and the coarse rinse processing step includes: a step of lowering the plurality of substrates to immerse the plurality of substrates in the first rinse liquid; and a step of raising the plurality of substrates at a second rising speed lower than or equal to the first rising speed to pull up the plurality of substrates from the first rinse liquid.

A seventh aspect of the substrate processing method is the substrate processing method according to any one of the first to sixth aspects, which include: a first step of transferring the plurality of substrates to a first carrier after the coarse rinse processing step; a second step of transferring the first carrier to a load port of a single-substrate-type processing apparatus after the first step; a third step of transferring the plurality of substrates one by one from the first carrier of the load port to a single-substrate processing unit between the second step and the single-substrate drying processing step; and a fourth step of transferring the substrates from the single-substrate processing unit to a second carrier of the load port after the single-substrate drying processing step.

An eighth aspect of the substrate processing method is the substrate processing method according to the seventh aspect, in which the first carrier includes a water-absorbing member that is partially in contact with the out-of-pattern region of each of the plurality of substrates without the pattern formed thereon.

A first aspect of a substrate processing apparatus includes: a phosphoric acid processing unit that has a processing tank and immerses a plurality of substrates in phosphoric acid inside the processing tank; a coarse rinse processing unit that replaces a part of the phosphoric acid adhering to the plurality of substrates with a rinse liquid to an extent that the phosphoric acid remains in patterns of the plurality of substrates; and a single-substrate processing unit that dries the plurality of substrates one by one.

A second aspect of the substrate processing apparatus is the substrate processing apparatus according to the first aspect, which includes a form changing unit that changes forms of the plurality of substrates between a horizontal form and an upright form, in which the phosphoric acid processing unit immerses the plurality of substrates in the upright form in the phosphoric acid inside the processing tank, and the single-substrate processing unit performs drying processing on the substrates in the horizontal form.

### EFFECTS OF THE INVENTION

According to the first aspect of the substrate processing method and the first and second aspects of the substrate processing apparatus, since the phosphoric acid is less likely to be evaporated, it is possible to suppress drying of the substrates between the coarse rinse processing step and the single-substrate drying processing step. Accordingly, pattern collapse caused by the drying can be suppressed.

According to the second aspect of the substrate processing method, the drying of the substrates can be effectively suppressed.

According to the third aspect of the substrate processing method, since the temperature of the first rinse liquid is initially high, rapid cooling of the substrates can be suppressed, and substrate damage caused by the rapid cooling can be suppressed. Further, by reducing the temperature of the first rinse liquid, the phosphoric acid in the patterns is less likely to be replaced with the first rinse liquid. Accordingly, the phosphoric acid is likely to remain in the patterns.

According to the fourth aspect of the substrate processing method, it is possible to reduce the liquid adhering to the out-of-pattern regions of the substrates. Accordingly, it is possible to suppress adhesion of the liquid to a transfer apparatus for the substrates.

According to the fifth aspect of the substrate processing method, since the steam of the second rinse liquid acts on the out-of-pattern regions, the liquid adhering to the out-of-pattern regions can be replaced with the second rinse liquid. Since the second rinse liquid is likely to be evaporated, the liquid in the out-of-pattern regions can be effectively removed. Further, since it is less likely to replace the phosphoric acid inside the patterns with the second rinse liquid due to action of the steam, the phosphoric acid inside the patterns can be left. Accordingly, the pattern collapse can be appropriately suppressed.

According to the sixth aspect of the substrate processing method, since the plurality of substrates are raised at a low second rising speed, an amount of the first rinse liquid adhering to the out-of-pattern region of each of the substrates subjected to coarse rinse processing can be reduced. Accordingly, it is possible to suppress the adhesion of the liquid to the transfer apparatus for the substrates.

According to the seventh aspect of the substrate processing method, since the first carrier houses the substrates after the coarse rinse processing step, the first carrier may be wet, but the substrates after the single-substrate drying processing step are housed in the second carrier different from the first carrier. Accordingly, it is possible to avoid the adhesion of the liquid to the substrates after the single-substrate drying processing step.

According to the eighth aspect of the substrate processing method, since the liquid adhering to the out-of-pattern regions are absorbed, it is possible to suppress the adhesion of the liquid to the transfer apparatus that transfers the substrates.

### BRIEF DESCRIPTION OF DRAWINGS

Fig. 1 shows a plan view schematically showing an example of a configuration of a substrate processing apparatus according to a first embodiment.
Fig. 2 shows a cross-sectional view partially and schematically showing an example of a three-dimensional structure of a substrate.
Fig. 3 shows a diagram schematically showing an example of a configuration of a coarse rinse processing unit.
Fig. 4 shows a diagram schematically showing an example of a configuration of a single-substrate processing unit.
Fig. 5 shows a flowchart showing an example of operations of the substrate processing apparatus according to the first embodiment.
Fig. 6 shows a graph showing steam pressure curves.
Fig. 7 shows a flowchart showing a specific example of coarse rinse processing.
Fig. 8 shows a diagram schematically showing an example of a configuration of a coarse rinse processing unit according to a second embodiment.
Fig. 9 shows a diagram schematically showing an example of the configuration of the coarse rinse processing unit according to the second embodiment.
Fig. 10 shows a flowchart showing an example of operations of a substrate processing apparatus according to a third embodiment.
Fig. 11 shows a front view schematically showing an example of a configuration of a carrier.
Fig. 12 shows an enlarged view schematically showing an example of a part of the configuration of the carrier.
Fig. 13 shows an enlarged view schematically showing an example of a part of another configuration of the carrier.

### DESCRIPTION OF EMBODIMENTS

Embodiments will be described below with reference to the accompanying drawings. Note that components described in the present embodiment are merely examples, and the scope of the present disclosure is not intended to be limited the components. In the drawings, dimensions or the number of respective units may be exaggerated or simplified as necessary for easy understanding.

Expressions indicating relative or absolute positional relationships (for example, "in one direction", "along one direction", "parallel", "orthogonal", "center", "concentric", and "coaxial") not only represent the positional relationships strictly, but also represent states of being relatively displaced with respect to angles or distances within a range in which tolerances or equivalent functions can be obtained, unless otherwise specified. Expressions indicating equal states (for example, "same", "equal", and "homogeneous") not only represent states of being quantitatively and strictly equal, but also represent states where there are differences that allow tolerances or equivalent functions to be obtained, unless otherwise specified. Expressions indicating shapes (for example, "quadrangular" or "cylindrical") not only represent the shape geometrically and strictly, but also represents a shape having, for example, unevenness or chamfering within a range in which the same level of effect can be obtained, unless otherwise specified. Expression "comprising", "installed with", "equipped with", "including", or "having" one component is not an exclusive expression of excluding presence of other components. Expression "at least any one of A, B, and C" includes only A, only B, only C, any two of A, B and C, and all of A, B and C.

### <First Embodiment>

### <Overall Configuration of Substrate Processing Apparatus>

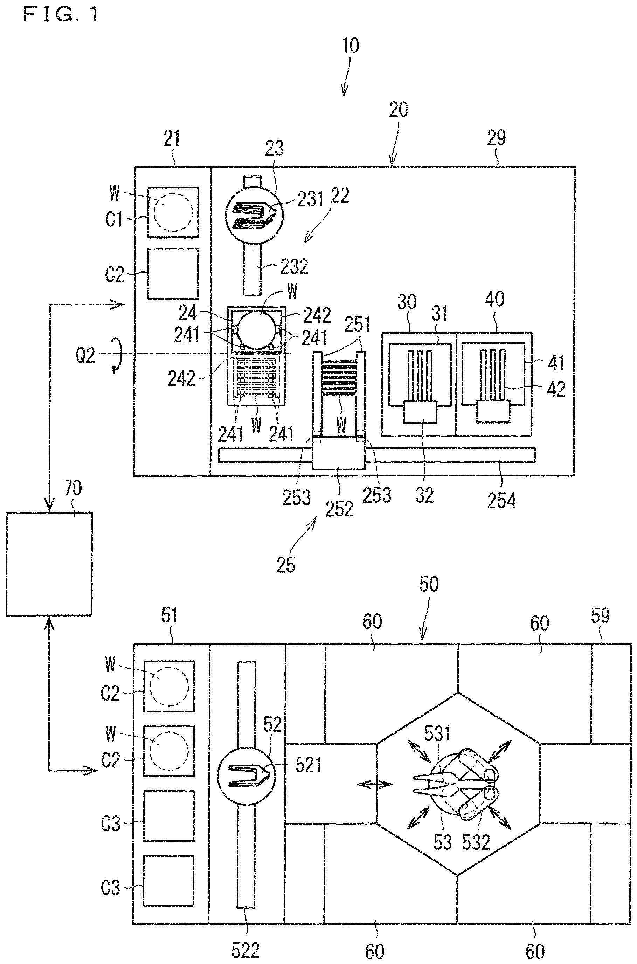

Fig. 1 shows a plan view schematically showing an example of a configuration of a substrate processing apparatus 10. The substrate processing apparatus 10 is an apparatus that performs wet processing on substrates W.

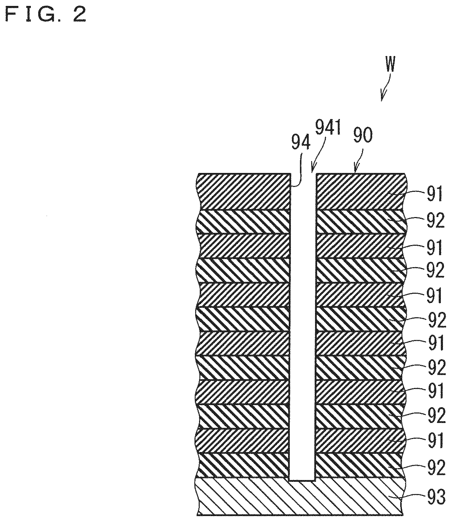

The substrate W is, for example, a semiconductor substrate that has a three-dimensional structure (hereinafter, referred to as pattern) formed on a main surface thereof. As a more specific example, the three-dimensional structure during manufacturing of a three-dimensional NAND (Not-AND) flash memory is formed on the main surface of the substrate W. Fig. 2 shows a cross-sectional view partially and schematically showing an example of the three-dimensional structure of the substrate W. In the example of Fig. 2, the substrate W includes a support layer 93. The support layer 93 is, for example, a silicon layer. A laminated structure 90 is formed on the support layer 93. The laminated structure 90 includes a plurality of insulating films 91 and a plurality of sacrificial films 92. Insulating films 91 and sacrificial films 92 are alternately laminated in a Z-axis direction. The insulating films 91 are, for example, silicon dioxide films, and the sacrificial films 92 are, for example, silicon nitride films. The insulating films 91 and the sacrificial films 92 have thicknesses of, for example, 1 nm or more and 50 nm or less. Further, a trench 94 is formed in a laminated structure 90. The trench 94 penetrates the laminated structure 90 in a thickness direction of the substrate W. Further, a pillar not shown is disposed in the laminated structure 90. The pillar supports the insulating films 91 in a case where the sacrificial films 92 are removed. A width of the pillar (a width parallel to the main surface of a substrate W) is, for example, 1 nm or more and 50 nm or less.

Regarding the present embodiment, as a specific example, a case where the substrate processing apparatus 10 etches the sacrificial films 92 will be described, but the substrate processing apparatus 10 may perform other processing on the substrate W.

As shown in Fig. 1, the substrate processing apparatus 10 includes a batch-type first processing apparatus 20, a single-substrate type second processing apparatus 50, and an inter-apparatus transfer unit 70.

The first processing apparatus 20 includes a load port 21, a transfer unit 22, a phosphoric acid processing unit 30, and a coarse rinse processing unit 40. The load port 21 is a carry-in and carry-out port for a plurality of substrates W to be received from and delivered to outside. The plurality of substrates W are carried into the load port 21 in a state where the substrates are housed in a portable container (hereinafter, referred to as carrier) C1. In the carrier C1, the plurality of substrates W are housed, for example, in a horizontal form and in a state where the substrates are arranged in a vertical direction. The horizontal form referred to herein is a form in which the thickness direction of the substrate W is along the vertical direction. Here, the substrates W are housed in the carrier C1 in a form in which front surfaces of the substrates W face vertically upward. The number of the substrates W to be housed in the carrier C1 is not particularly limited, but is, for example, 25.

As the carrier C1, a front opening unified pod (FOUP) that houses the substrates W in a sealed space, a standard mechanical interface (SMIF) pod, or an open cassette (OC) that exposes the substrates W to outside air, may be adopted.

In the example of Fig. 1, a carrier C2 (corresponding to the first carrier) is also carried into the load port 21. In the load port 21, the carrier C1 and the carrier C2 are arranged side by side in a horizontal first arrangement direction. The carrier C2 has a configuration similar to that of the carrier C1. However, as described later, the carrier C2 is used to transfer the plurality of substrates W between the first processing apparatus 20 and the second processing apparatus 50.

In the example of Fig. 1, the first processing apparatus 20 includes a housing 29, and at least the transfer unit 22, the phosphoric acid processing unit 30, and the coarse rinse processing unit 40 are disposed inside the housing 29.

The transfer unit 22 transfers the plurality of substrates W among the load port 21, the phosphoric acid processing unit 30, and the coarse rinse processing unit 40. In the example of Fig. 1, the transfer unit 22 includes a transfer robot 23, a form changing unit 24, and a transfer robot 25.

The transfer robot 23 is disposed to be movable in the first arrangement direction of the carrier C1 and the carrier C2 by a moving mechanism 232. The transfer robot 23 can stop at a position facing each of the carrier C1 and the carrier C2. The moving mechanism 232 includes, for example, a mechanism such as a ball screw mechanism having a motor.

The transfer robot 23 takes out the plurality of substrates W unprocessed from the carrier C1 of the load port 21, and delivers the plurality of substrates W to the form changing unit 24. For example, the transfer robot 23 includes a plurality of hands 231 and a hand moving mechanism (not shown). The hand moving mechanism has, for example, an arm mechanism, a lifting mechanism, and a turning mechanism, each of which includes a motor. The hand moving mechanism moves the hands 231 in a horizontal direction and the vertical direction. The transfer robot 23 takes out the plurality of substrates W from the carrier C1 by moving the plurality of hands 231 at a position to face the carrier C1. In this way, one substrate W is placed on each of the hands 231. Then, the transfer robot 23 delivers the plurality of substrates W to the form changing unit 24 by moving the hands 231 holding the substrates W.

The form changing unit 24 changes the forms of the plurality of substrates W from the horizontal form to an upright form. The upright form referred to herein is a form in which the thickness direction of the substrate W is along the horizontal direction. The form changing unit 24 includes holding members 241, rotating members 242, and a rotating mechanism (not shown). The rotating members 242 are rotatably disposed around a predetermined rotation axis Q2. The rotation axis Q2 is an axis extending in the horizontal direction. The holding members 241 are attached to the rotating members 242 and hold the plurality of substrates W. The rotating mechanism includes a motor, and rotates the rotating members 242 about the rotation axis Q2 by 90 degrees between an upright rotation position and a horizontal rotation position. In this way, the forms of the plurality of substrates W held by the holding members 241 are changed between the horizontal form and the upright form.

Each of the holding members 241 has an elongated shape elongated in a predetermined longitudinal direction, and in a state where the rotating members 242 are located at the horizontal rotation position, a longitudinal direction of the each of the holding members 241 is along the vertical direction. In the example of Fig. 1, four holding members 241 are disposed. A plurality of grooves (not shown) are formed in the holding members 241 side by side in the longitudinal direction. Pitches of the grooves are equal to pitches of the plurality of substrates W. Since end portions of the substrates W are inserted into corresponding grooves of the each of the holding members 241, the holding members 241 support the each of the substrates W at four points. In the example of Fig. 1, the form changing unit 24 holding the plurality of substrates W in the horizontal form is indicated by a solid line.

As the rotating members 242 rotate from the horizontal rotation position to the upright rotation position, the longitudinal direction of the holding members 241 is along the horizontal direction, and the forms of the substrates W are changed from the horizontal form to the upright form. In the example of Fig. 1, the form changing unit 24 holding the plurality of substrates W in the upright form is indicated by a two-dot chain line.

The transfer robot 25 receives the plurality of substrates W from the form changing unit 24, and transfers the plurality of substrates W to the phosphoric acid processing unit 30. In the example of Fig. 1, the transfer robot 25 includes a pair of holding members 251, a base 252, and a switching mechanism 253. The holding members 251 are attached to be displaceable with respect to the base 252. The switching mechanism 253 moves the holding members 251 between an opening position and a closing position. The closing position is a position where an interval between the two holding members 251 is narrow, and is a position where the holding members 251 sandwich the plurality of substrates W. The opening position is a position where the interval between the two holding members 251 is wide, and is a position where the holding members 251 release holding of the plurality of substrates W. The switching mechanism 253 includes, for example, a motor. The transfer robot 25 is disposed to be movable along a horizontal transfer direction by a moving mechanism 254. Specifically, the moving mechanism 254 moves the base 252 in the transfer direction. In this way, the holding members 251, the base 252, and the switching mechanism 253 integrally move in the transfer direction. The moving mechanism 254 includes, for example, the mechanism such as the ball screw mechanism including the motor.

The phosphoric acid processing unit 30 is a batch-type processing apparatus that collectively performs phosphoric acid processing on the plurality of substrates W. In the example of Fig. 1, the phosphoric acid processing unit 30 includes a processing tank 31 and a lifter 32. The processing tank 31 stores phosphoric acid. The lifter 32 raises and lowers the plurality of substrates W between a delivery position and a processing position. The delivery position is a position vertically above an upper end of the processing tank 31, and is a position where the plurality of substrates W are delivered between the lifter 32 and the transfer robot 25. The processing position is a position where the plurality of substrates W are immersed in the phosphoric acid inside the processing tank 31.

Since the lifter 32 lowers the plurality of substrates W to the processing position, the plurality of substrates W are immersed in the phosphoric acid inside the processing tank 31. In this way, the phosphoric acid acts on the sacrificial films 92 through the trench 94 of the each of the substrates W, and etches and removes the sacrificial films 92. When the sacrificial films 92 are removed, the insulating films 91 are no longer supported by the sacrificial films 92, and thus are likely to collapse.

The transfer robot 25 receives the plurality of substrates W subjected to the phosphoric acid processing from the phosphoric acid processing unit 30, and transfers the plurality of substrates W to the coarse rinse processing unit 40. In the example of Fig. 1, the coarse rinse processing unit 40 is disposed at a position adjacent to the phosphoric acid processing unit 30 in the transfer direction of the transfer robot 25.

The coarse rinse processing unit 40 performs the coarse rinse processing on the plurality of substrates W subjected to the phosphoric acid processing by the phosphoric acid processing unit 30. The coarse rinse processing is processing of replacing a part of the phosphoric acid adhering to the plurality of substrates W with a first rinse liquid to an extent that the phosphoric acid remains in the patterns of the plurality of substrates W (for example, in the trenches 94 and between two of the insulating films 91). The first rinse liquid is, for example, pure water.

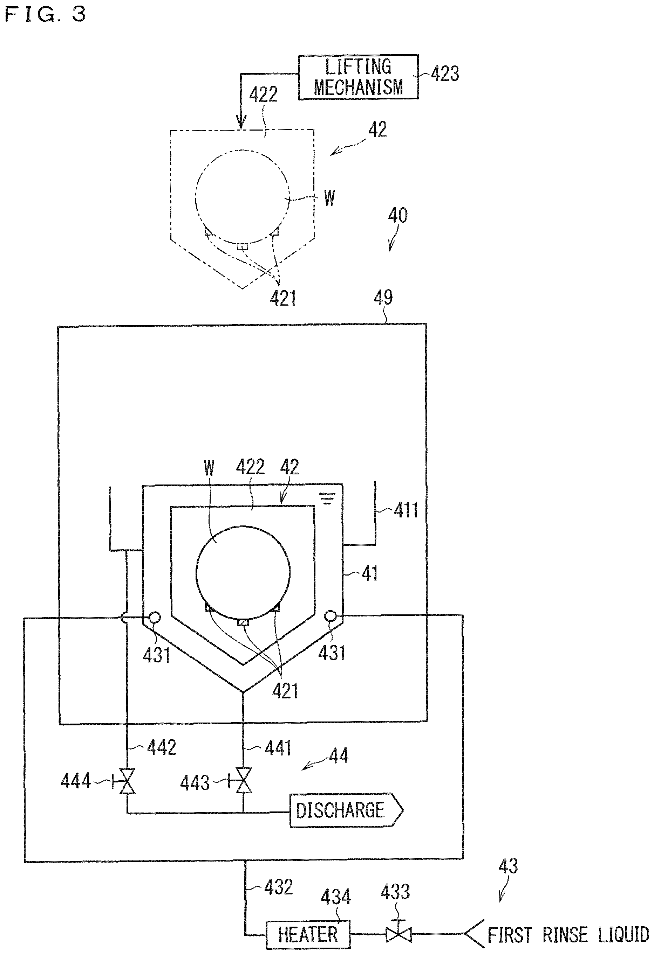

Fig. 3 shows a diagram schematically showing an example of a configuration of the coarse rinse processing unit 40. In the example of Fig. 3, the coarse rinse processing unit 40 includes a processing tank 41, a lifter 42, a rinse liquid supply unit 43, a discharge unit 44, and a chamber 49.

The processing tank 41 has a box shape opened vertically upward, and stores the rinse liquid. The processing tank 41 is disposed in the chamber 49. An openable and closable lid (also be referred to as a shutter) is disposed on an upper portion of the chamber 49. In a state where the lid of the chamber 49 is opened, the plurality of substrates W are carried into an inner portion of the chamber 49 through an upper opening, or carried out from the inner portion of the chamber 49 through the upper opening.

The lifter 42 raises and lowers the plurality of substrates W. In the example of Fig. 3, the lifter 42 includes a plurality of (three in the drawing) holding members 421 that hold the plurality of substrates W in the upright form, a base 422 that supports the holding members 421, and a lifting mechanism 423 that raises and lowers the base 422. The each of the holding members 421 has an elongated shape extending in the thickness direction (a direction perpendicular to a paper surface referred to in Fig. 3) of the substrate W, and has a base end portion attached to the base 422. A plurality of grooves (not shown) is formed in the each of the holding members 421 side by side in the longitudinal direction of the holding members. The pitches of the grooves are equal to the pitches of the plurality of substrates W. Since the end portions of the substrates W are inserted into the corresponding grooves of the each of holding members 421, the plurality of holding members 421 hold the plurality of substrates W in the upright form. The base 422 has a plate shape, and is disposed in a form in which a thickness direction of the base 422 is along the longitudinal direction of the each of the holding members 421. The lifting mechanism 423 raises and lowers the plurality of substrates W held by the holding members 421 by raising and lowering the base 422. The lifting mechanism 423 includes, for example, the ball screw mechanism including the motor, a cam mechanism, or a mechanism such as an air cylinder. Hereinafter, a subject being raised and lowered by the lifting mechanism 423 may be described as the lifter 42.

The lifter 42 raises and lowers the plurality of substrates W between the delivery position vertically above the processing tank 41 and a processing position in the processing tank 41. In the example of Fig. 3, the delivery position is a position vertically above the chamber 49, and is a position where the plurality of substrates is delivered between the lifter 42 and the transfer unit 22. In the example of Fig. 3, the lifter 42 located at the delivery position is indicated by the two-dot chain line. The processing position is a position where the plurality of substrates W are immersed in a processing liquid.

The rinse liquid supply unit 43 supplies the first rinse liquid to the processing tank 41. In the example of Fig. 3, the rinse liquid supply unit 43 includes nozzles 431, a liquid supply pipe 432, and a valve 433. In the example of Fig. 3, the nozzles 431 are disposed in a lower portion in the processing tank 41. A downstream end of the liquid supply pipe 432 is connected to the nozzles 431, and an upstream end of the liquid supply pipe 432 is connected to a rinse liquid supply source. The rinse liquid supply source has a tank (not shown) that stores the first rinse liquid.

The valve 433 is interposed in the liquid supply pipe 432. Since the valve 433 is opened, the first rinse liquid is supplied from the rinse liquid supply source to the nozzles 431 through the liquid supply pipe 432, and the first rinse liquid is discharged from discharge ports of the nozzles 431 into the processing tank 41. Since the valve 433 is closed, supply of the first rinse liquid into the processing tank 41 ends.

In the example of Fig. 3, a heater 434 is disposed in the liquid supply pipe 432. The heater 434 heats the first rinse liquid. In this way, the first rinse liquid heated is supplied to the processing tank 41.

In the example of Fig. 3, an upflow tank 411 is disposed in the coarse rinse processing unit 40. The upflow tank 411 is an outer tank that receives the first rinse liquid overflowing from an upper end of the processing tank 41.

A discharge unit 44 discharges the first rinse liquid from the processing tank 41 and the upflow tank 411. The discharge unit 44 includes a liquid discharge pipe 441, a liquid discharge pipe 442, a valve 443, and a valve 444. An upstream end of the liquid discharge pipe 441 is connected to, for example, a bottom portion of the processing tank 41, and an upstream end of the liquid discharge pipe 442 is connected to, for example, a bottom of the upflow tank 411.

The valve 443 and the valve 444 are interposed in the liquid discharge pipe 441 and the liquid discharge pipe 442, respectively. Since the valve 443 is opened, the first rinse liquid inside the processing tank 41 is discharged to the outside through the liquid discharge pipe 441, and since the valve 443 is closed, discharge of the first rinse liquid inside the processing tank 41 ends. Since the valve 444 is opened, the first rinse liquid in the upflow tank 411 is discharged to the outside through the liquid discharge pipe 442, and since the valve 444 is closed, discharge of the first rinse liquid in the upflow tank 411 ends.

The lifter 42 of the coarse rinse processing unit 40 can perform the coarse rinse processing by immersing the plurality of substrates W subjected to the phosphoric acid processing in the first rinse liquid inside the processing tank 41 for a short time.

Further, the valve 433 and the valve 444 may be opened during the coarse rinse processing. In this way, the first rinse liquid supplied into the processing tank 41 by the rinse liquid supply unit 43 flows vertically upward in the processing tank 41. Then, the first rinse liquid overflows from an upper portion of the processing tank 41, and is discharged to the outside through the upflow tank 411 and the liquid discharge pipe 441. In this manner, a liquid flow directed vertically upward (so-called an upflow) is formed in the processing tank 41. Therefore, adhesion of impurities to the substrates W can be suppressed.

The transfer robot 25 receives the plurality of substrates W subjected to the coarse rinse processing from the coarse rinse processing unit 40, and transfers the plurality of substrates W to the form changing unit 24. The form changing unit 24 changes the forms of the substrates W from the upright form to the horizontal form. The transfer robot 23 receives the plurality of substrates W in the horizontal form from the form changing unit 24, and transfers the plurality of substrates W to the carrier C2 of the load port 21.

The inter-apparatus transfer unit 70 takes out the carrier C2 subjected to the coarse rinse processing from the load port 21 of the first processing apparatus 20, and transfers the carrier C2 to the second processing apparatus 50. The inter-apparatus transfer unit 70 includes a carrier holding unit and a moving mechanism, none of which are shown. The carrier holding unit is a member that hold the carrier C2. A held member to be held by the carrier holding unit is disposed on, for example, an upper portion of the carrier C2, and the carrier holding unit grips the non-holding member. The moving mechanism includes, for example, a motor, and moves the carrier holding units between the first processing apparatus 20 and the second processing apparatus 50.

The second processing apparatus 50 includes a load port 51, an indexer robot 52, a transfer robot 53, and single-substrate processing units 60. The load port 51 is a carry-in and carry-out port for the plurality of substrates W to be received from and delivered to the outside. The plurality of substrates W are carried into the load port 51 by the inter-apparatus transfer unit 70 in a state where the substrates are housed in the carrier C2. Further, in the example of Fig. 1, carriers C3 (corresponding to the second carrier) are also carried into the load port 51. In the load port 51, the carriers C2 and the carriers C3 are arranged in a horizontal second arrangement direction. The carrier C3 has the same configuration as those of the carrier C1 and the carrier C2. However, the carriers C3 are used to transfer the plurality of substrates W from the second processing apparatus 50 to a downstream side apparatus (not shown).

In the example of Fig. 1, the second processing apparatus 50 includes a housing 59. At least the indexer robot 52, the transfer robot 53, and the single-substrate processing units 60 are disposed inside the housing 59.

The indexer robot 52 is disposed to be movable along the second arrangement direction by a moving mechanism 522, and can stop at a position to face each of the carriers C2 and the carriers C3. The indexer robot 52 includes hands 521 and a hand moving mechanism (not shown). The indexer robot 52 transfers the substrates W between the load port 51 and the transfer robot 53 by moving the hands 521.

The transfer robot 53 transfers the substrates W between the indexer robot 52 and the single-substrate processing units 60. In the example of Fig. 1, a plurality of the single-substrate processing units 60 are disposed around the transfer robot 53. Specifically, four single-substrate processing units 60 are disposed to surround the transfer robot 53. The transfer robot 53 includes hands 531 and a hand moving mechanism 532. The transfer robot 53 transfers the substrates W between the indexer robot 52 and the single-substrate processing units 60 by moving the hands 531.

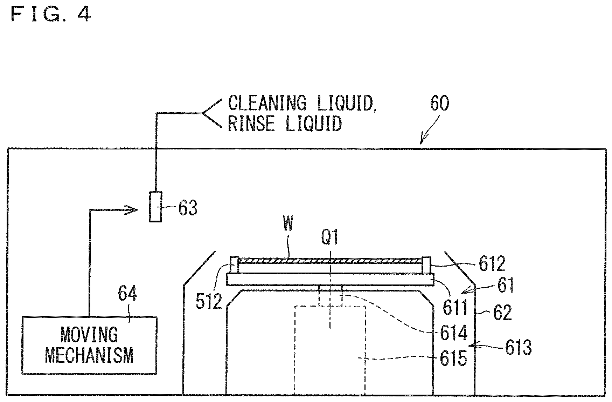

Each of the single-substrate processing units 60 performs the drying processing on at least the substrates W one by one. The drying processing is not particularly limited, but may be spin drying, for example. Fig. 4 shows a diagram schematically showing an example of a configuration of the single-substrate processing unit 60. The single-substrate processing unit 60 includes a substrate holding unit 61. The substrate holding unit 61 holds the substrates W in the horizontal form. In the example of Fig. 4, the substrate holding unit 61 includes a stage 611 and a plurality of chuck pins 612. The stage 611 has a disk shape and is disposed vertically below the substrate W. The stage 611 is disposed in a form in which a thickness direction of the stage is along the vertical direction.

The plurality of chuck pins 612 is erected on an upper surface of the stage 611. Each of the plurality of chuck pins 612 is disposed to be displaceable between a chuck position in contact with a peripheral edge of the substrate W and a release position away from the peripheral edge of the substrate W. In a case where the plurality of chuck pins 612 move to corresponding chuck positions, the plurality of chuck pins 612 hold the substrate W. In a case where the plurality of chuck pins 612 move to corresponding release positions, holding of the substrate W is released.

In the example of Fig. 4, the substrate holding unit 61 further includes a rotating mechanism 613, and rotates the substrate W around a rotation axis Q1. The rotation axis Q1 is an axis passing through a center portion of the substrate W and extending in the Z-axis direction. For example, the rotating mechanism 613 includes a shaft 614 and a motor 616. An upper end of the shaft 614 is connected to a lower surface of the stage 611, and extends from the lower surface of the stage 611 along the rotation axis Q1. The motor 616 rotates the shaft 614 around the rotation axis Q1 to integrally rotate the stage 611 and the plurality of chuck pins 612. In this way, the substrate W held by the plurality of chuck pins 612 rotates around the rotation axis Q1. Such substrate holding unit 61 may also be referred to as a spin chuck.

Since the substrate holding unit 61 rapidly rotates the substrate W around the rotation axis Q1, a liquid adhering to the substrate W can be scattered from the peripheral edge of the substrate W to dry the substrate W (so-called the spin drying).

In the example of Fig. 4, the single-substrate processing unit 60 also includes a guard 62. The guard 62 has a tubular shape and surrounds the substrate W held by the substrate holding unit 61. The guard 62 receives the liquid scattered from the peripheral edge of the substrate W.

In the example of Fig. 4, the single-substrate processing unit 60 also includes a nozzle 63. The nozzle 63 is used to supply a cleaning liquid and the rinse liquid to the substrate W as pre-processing before the drying processing. The cleaning liquid includes, for example, SC-1 (ammonia hydrogen peroxide water mixed liquid). The rinse liquid contains, for example, at least one of the pure water and isopropyl alcohol. The nozzle 63 is disposed to be movable between a nozzle processing position and a nozzle standby position by a moving mechanism 64. The nozzle processing position is, for example, a position facing a central portion of the front surface of the substrate W in the Z-axis direction, and the nozzle standby position is, for example, a position radially outside the substrate W. The moving mechanism 64 includes, for example, a mechanism such as the ball screw mechanism or an arm turning mechanism. The rinse liquid is discharged to the substrate W in rotation in a state where the nozzle 63 is located at the nozzle processing position. In this way, the cleaning liquid or the rinse liquid adhering to the front surface of the substrate W receives a centrifugal force, spreads over the entire front surface of the substrate W, and scatters outward from the peripheral edge of the substrate W. In this way, cleaning processing and the rinse processing can be performed on the substrate W.

### <Example of Operations of Substrate Processing Apparatus>

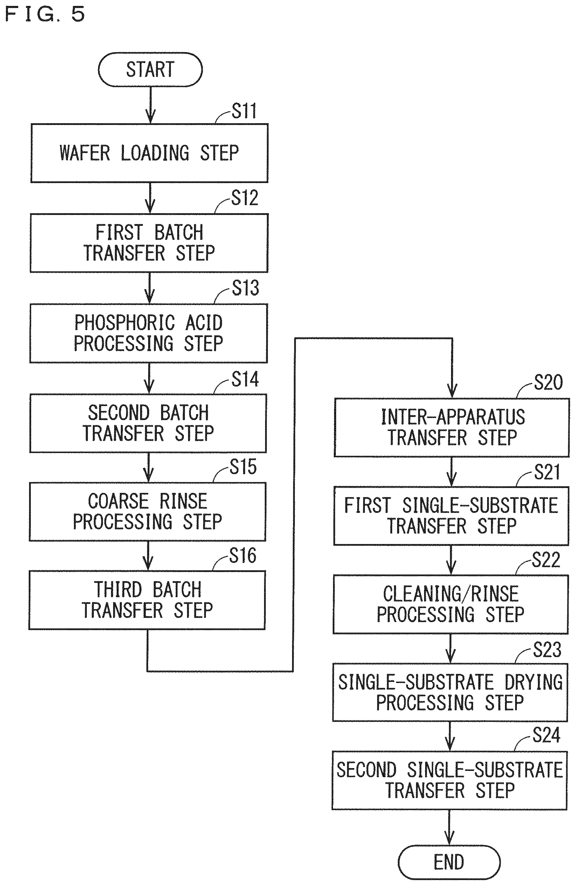

Fig. 5 shows a flowchart schematically showing an example of a processing step for the substrates W. First, the carrier C1 housing the plurality of substrates W unprocessed is carried into the load port 21 of the first processing apparatus 20 by a transfer apparatus not shown (step S 11: a wafer loading step).

Next, the transfer unit 22 takes out the plurality of substrates W from the carrier C1, changes the forms of the substrates W from the horizontal form to the upright form, and transfers the plurality of substrates W in the upright form to the phosphoric acid processing unit 30 (step S12: a first batch transfer step). In this way, the plurality of substrates W is delivered to the lifter 32 of the phosphoric acid processing unit 30.

Next, the phosphoric acid processing unit 30 collectively performs the phosphoric acid processing on the plurality of substrates W (step S13: a phosphoric acid processing step). Specifically, the lifter 32 lowers the plurality of substrates W to the processing position. In this way, the plurality of substrates W are immersed in the phosphoric acid inside the processing tank 31. A concentration of the phosphoric acid is, for example, 80% or more, and as a more specific example, about 86%. Here, a temperature of the phosphoric acid is maintained at, for example, about 160 degrees. For example, a circulation pipe may be disposed in the processing tank 31, and a heater may be disposed in the circulation pipe. Since the heater heats the phosphoric acid flowing through the circulation pipe, the temperature of the phosphoric acid inside the processing tank 31 can be adjusted.

As the plurality of substrates W are immersed in the phosphoric acid inside the processing tank 31, the phosphoric acid acts on the sacrificial films 92 through the trenches 94 to etch and remove the sacrificial films 92.

When the sacrificial films 92 are sufficiently removed, the lifter 32 raises the plurality of substrates W to the delivery position to pull up the plurality of substrates W from the processing tank 31.

Next, the transfer unit 22 receives the plurality of substrates W subjected to the phosphoric acid processing from the lifter 32 of the phosphoric acid processing unit 30, and transfers the plurality of substrates W to the coarse rinse processing unit 40 (step S14: a second batch transfer process). In this way, the plurality of substrates W is delivered to the lifter 42 of the coarse rinse processing unit 40.

Next, the coarse rinse processing unit 40 collectively performs the coarse rinse processing on the plurality of substrates W (step S15: a coarse rinse processing step). Specifically, the lifter 42 lowers the plurality of substrates W in the upright form to the processing position at first. In this way, the plurality of substrates W are immersed in the first rinse liquid inside the processing tank 41.

In this way, the phosphoric acid adhering to the plurality of substrates W is gradually replaced with the first rinse liquid over time. More specifically, the phosphoric acid inside the pattern of the each of the substrates W (here, inside the trenches 94 and between the two of the insulating films 91) gradually flows from an opening 941 of the each of the substrates to the outside, and instead, the first rinse liquid enters into the patterns. Therefore, the phosphoric acid inside the patterns is relatively slowly replaced with the first rinse liquid.

On the other hand, in the out-of-pattern region of the each of the substrates W without the pattern formed thereon, the phosphoric acid is relatively quickly replaced with the first rinse liquid. This is because the out-of-pattern region is flat. The out-of-pattern region referred to herein includes a peripheral edge region of the front surface of the each of the substrates W without the patterns formed thereon and back surfaces of the each of the substrates W.

The coarse rinse processing ends when the phosphoric acid remains inside the patterns. For example, the lifter 32 raises the plurality of substrates W to the delivery position in a state where the phosphoric acid remains inside the patterns, and pulls up the plurality of substrates W from the first rinse liquid. In this way, the coarse rinse processing substantially ends. More specifically, the lifter 32 pulls up the plurality of substrates W from the first rinse liquid when a prescribed processing period of time has elapsed after the plurality of substrates W are immersed in the first rinse liquid. Lapse of the processing period of time is measured by, for example, a timer circuit (not shown). The processing period of time is set in advance to a period of time to an extent that the phosphoric acid sufficiently remains inside the pattern of the each of the substrates W. For example, the extent to which the phosphoric acid remains sufficiently inside the patterns means that the processing period of time is set in advance such that the concentration of the phosphoric acid inside the patterns (for example, a mass concentration is 50% or more, that is, the concentration of the phosphoric acid inside the patterns) does not fall below 50%. The processing period of time is set by simulation or experiment, for example, and is set to about 2 minutes to 5 minutes as a specific example.

As described above, the phosphoric acid in low concentration remains inside the pattern of the each of the substrates W by the coarse rinse processing.

Incidentally, since the phosphoric acid processing unit 30 immerses the plurality of substrates W in the phosphoric acid at a high temperature as described above, the substrates W subjected to the phosphoric acid processing have a high temperature. In a case where the substrates W at the high temperature are immersed in the first rinse liquid at a low temperature, there is a possibility that the substrates W are damaged due to rapid cooling.

Therefore, the coarse rinse processing unit 40 may adjust a temperature of the first rinse liquid inside the processing tank 41 to a temperature higher than a normal temperature and lower than the temperature of the phosphoric acid during the phosphoric acid processing, for example, about 60°C. For example, the heater 434 may heat the first rinse liquid flowing through the liquid supply pipe 432, and supply the first rinse liquid heated into the processing tank 41. By heating control of a heater 424, the temperature of the first rinse liquid inside the processing tank 41 can be adjusted.

In this way, since the temperature of the first rinse liquid is higher than the normal temperature (for example, 25°C), the rapid cooling of the substrates W can be suppressed, and damage to the substrates W can be alleviated.

Further, in the coarse rinse processing, the valve 433 and the valve 444 may be opened. In this way, the first rinse liquid supplied from the nozzle 431 into the processing tank 41 flows vertically upward in the processing tank 41, overflows from the upper portion of the processing tank 41, is received by the upflow tank 411, and discharged to the outside through the liquid discharge pipe 442. In this way, the liquid flow (so-called the upflow) directed from a vertically lower side to a vertically upper side is formed in the processing tank 41. Accordingly, it is possible to suppress adhesion of impurities in the first rinse liquid to the substrates W.

Next, the transfer unit 22 receives the plurality of substrates W from the lifter 42 of the coarse rinse processing unit 40, changes the forms of the substrates W from the upright form to the horizontal form, and transfers the plurality of substrates W in the horizontal form to the carrier C2 of the load port 21 (step S16: a third batch transfer step corresponding to the first step). Here, the substrates W are housed in the carrier C2 in a form in which the front surfaces of the substrates faces vertically upward.

Next, the inter-apparatus transfer unit 70 takes out the carrier C2 from the load port 21 of the first processing apparatus 20, and transfers the carrier C2 to the load port 51 of the second processing apparatus 50 (step S20: an inter-apparatus transfer step corresponding to the second step).

Next, the indexer robot 52 and the transfer robot 53 sequentially transfer the substrates W from the carrier C2 of the load port 51 to the each of the single-substrate processing units 60 (step S21: a first single-substrate transfer corresponding to the third step). In this way, the substrate holding unit 61 of the each of the single-substrate processing units 60 holds the substrate W in the horizontal form.

Next, the single-substrate processing unit 60 performs cleaning/rinse processing on the substrate W (step S22: a cleaning/rinse processing step). Specifically, the substrate holding unit 61 rotates the substrate W around the rotation axis Q1, and the moving mechanism 64 moves the nozzle 63 to the nozzle processing position. Then, the nozzle 63 discharges the first rinse liquid (for example, the pure water) onto the upper surface of the substrate W in rotation. The first rinse liquid adhering to the upper surface of the substrate W receives a centrifugal force accompanying rotation of the substrate W, spreads on the upper surface of the substrate W, and scatters outward from the peripheral edge of the substrate W. In this way, the phosphoric acid remaining on the substrate W can be replaced with the first rinse liquid. Next, the single-substrate processing unit 60 may discharge the cleaning liquid and the first rinse liquid from the nozzle 63 toward the substrates W in an order as necessary. Alternatively, the nozzle 63 may further discharge a second rinse liquid (for example, isopropyl alcohol) having latent heat of vaporization lower than that of the first rinse liquid toward the substrate W.

Next, the single-substrate processing unit 60 performs the drying processing on the substrate W (step S23: a single-substrate drying processing step). Specifically, the substrate holding unit 61 increases a rotation speed of the substrate W (so-called the spin drying). In this way, the substrate W is subjected to the drying processing. In a case where the substrate W is sufficiently dried, the substrate holding unit 61 ends the rotation of the substrate W.

Next, the transfer robot 53 and the indexer robot 52 transfer the substrates W from the single-substrate processing units 60 to the carrier C3 of the load port 51 (step S24: a second single-substrate transfer step corresponding to the fourth step).

In a case where the number of the substrates W in the carrier C3 reaches a predetermined number (here, 25), a transfer apparatus not shown takes out the carrier C3 from the load port 51 and transfers the carrier C3 to the processing apparatus on a further downstream side.

As described above, with the substrate processing apparatus 10, the batch-type phosphoric acid processing unit 30 can collectively perform the phosphoric acid processing on the plurality of substrates W (step S13). In this way, the sacrificial films 92 of the plurality of substrates W can be etched away with a high throughput. In particular, since it takes time to remove the sacrificial films 92 with the phosphoric acid, batch-type processing for collectively processing the plurality of substrates W is beneficial.

Moreover, after the phosphoric acid processing, the coarse rinse processing is performed (step S15). Accordingly, the phosphoric acid in low concentration is contained inside the patterns of the substrates W subjected to the coarse rinse processing. Since this phosphoric acid is less likely to be evaporated, the drying of the each of the substrates W can be suppressed during a period between the coarse rinse processing (step S15) and single-substrate-type processing (step S22). Therefore, pattern collapse of the substrates W (for example, collapse of the insulating films 91) due to the drying can be suppressed or avoided.

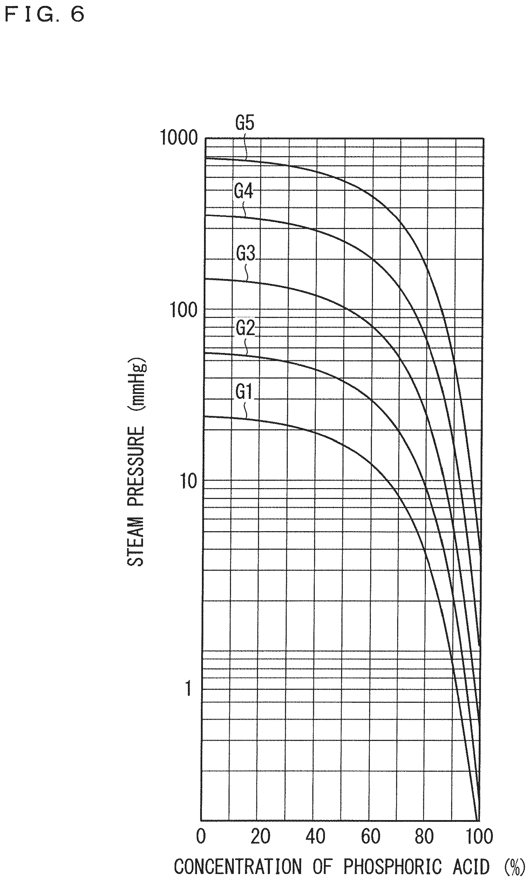

Fig. 6 shows a graph showing steam pressure curves of the phosphoric acid. Fig. 6 shows the steam pressure curves by graphs G1 to G5 for each temperature. The graphs G1 to G5 show steam pressures at temperatures of 25°C, 40°C, 60°C, 80°C and 100°C, respectively. As can be understood with reference to Fig. 6, the steam pressures of the phosphoric acid are lower than that of the pure water (that is, the phosphoric acid having a concentration of 0%). In particular, in a case where the concentration of the phosphoric acid is 50% or more, the steam pressures decrease more rapidly as the concentration increases. In other words, in the case where the concentration of the phosphoric acid is 50% or more, the phosphoric acid is remarkably less likely to be evaporated as compared with a case where the concentration of the phosphoric acid is less than 50%. Accordingly, by setting the processing period of time of the coarse rinse processing to an extent that the concentration of the phosphoric acid in the patterns subjected to the coarse rinse processing becomes 50% or more, the drying of the substrates W subjected to the coarse rinse processing can be more appropriately suppressed.

Note that the coarse rinse processing (step S15) may end in a state where the concentration of the phosphoric acid in the patterns becomes, for example, 60% or more, or may end in a state where the concentration becomes 70% or more.

Further, the substrates W subjected to the coarse rinse processing are subjected to the drying processing one by one by the single-substrate processing unit 60 (step S23). In a single-substrate type drying processing, since the substrates W are dried one by one, the substrates W can be dried with a high drying performance. Accordingly, the pattern collapse of the substrates W due to the drying processing can be suppressed or avoided.

Further, most or all of the phosphoric acid adhering to the out-of-pattern regions of the substrates W can be replaced with the first rinse liquid by the coarse rinse processing. This is because the out-of-pattern regions are flat as compared with regions where the patterns are formed, and thus the phosphoric acid in the out-of-pattern regions is likely to be replaced with the first rinse liquid even in the coarse rinse processing. Accordingly, in the coarse rinse processing, the most of the phosphoric acid in the out-of-pattern regions can be replaced with the first rinse liquid.

Incidentally, the substrates W subjected to the coarse rinse processing are sequentially held by the transfer unit 22, the carrier C2, the indexer robot 52, and the transfer robot 53, as described above. These components hold the plurality of substrates W in contact with the out-of-pattern regions (for example, the back surfaces of the substrates W). Since the most or the all of the phosphoric acid in the out-of-pattern regions can be replaced with the first rinse liquid by the coarse rinse processing, it is possible to suppress or avoid adhesion of the phosphoric acid to the out-of-pattern regions.

Further, in the examples described above, the carrier C2 are carried into the second processing apparatus 50. In other words, the substrates W wetted after the coarse rinse processing are transferred by the carrier C2. Accordingly, the liquid can also adhere to the carrier C2. Then, the substrates W subjected to the drying processing by the single-substrate processing units 60 are transferred to the carrier C3 different from the carrier C2 by the transfer robot 53 and the indexer robot 52. In this way, it is possible to avoid re-adhesion of the liquid to the substrates W due to the substrates W subjected to the drying processing being housed in the carrier C2.

### <Transfer of Carrier C2>

When the indexer robot 52 takes out all the substrates W from the carrier C2, the inter-apparatus transfer unit 70 may take out the carrier C2, which is empty, from the load port 51 and transfers the carrier C2 to the load port 21 of the first processing apparatus 20. In this way, the carrier C2 can be used again to transfer the plurality of substrates W from the first processing apparatus 20 to the second processing apparatus 50. Although an inner portion of the carrier C2 can be wetted by previous transfer of the substrates W, the plurality of substrates W treated by the first processing apparatus 20 are wetted. Therefore, no problem occurs even when the inner portion of the carrier C2 are wetted.

### <Hands>

The indexer robot 52 may include a plurality of the hands 521. In this case, the indexer robot 52 may include a forward hand 521 and a backward hand 521. In other words, the indexer robot 52 may transfer the substrates W from the carrier C2 to the transfer robot 53 with the forward hand 521, and transfer the substrates W from the transfer robot 53 to the carrier C3 with the backward hand 521. In this way, even when the liquid in the substrates W adheres to the forward hand 521, it is possible to suppress or avoid adhesion of the liquid to the substrates W subjected to the drying processing via the hand 521. Similarly, the transfer robot 53 may include a forward hand 531 and a backward hand 531.

### <Coarse rinse Processing (Temperature Reduction of First Rinse Liquid)>

Next, an example of temperature control in the coarse rinse processing will be described. In the examples described above, in the coarse rinse processing, the temperature of the first rinse liquid is set to a value (for example, about 60°C) higher than the normal temperature and lower than the temperature of the phosphoric acid in the phosphoric acid processing. In this way, the rapid cooling on the substrates W at the high temperature after the phosphoric acid processing has been suppressed, and the damage to the substrates W has been suppressed. However, as the temperature of the first rinse liquid increases, replacement of the phosphoric acid with the first rinse liquid proceeds more quickly. Then, an excessive decrease in the concentration of the phosphoric acid inside the patterns is undesirable from a viewpoint of suppressing the drying of the substrates W subjected to the coarse rinse processing.

Therefore, as described below, the substrate processing apparatus 10 may reduce the temperature of the first rinse liquid in the coarse rinse processing.

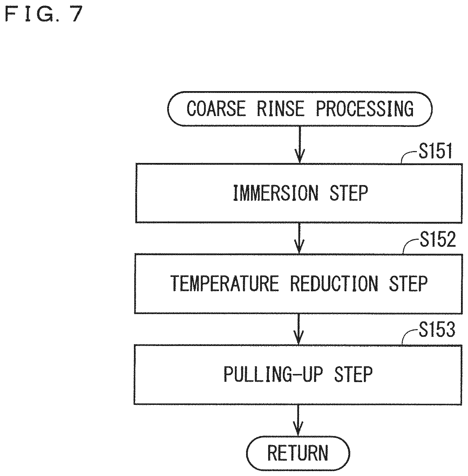

Fig. 7 shows a flowchart showing a specific example of the coarse rinse processing step. Initially, the rinse liquid at a first temperature (for example, 60°C) is stored in the processing tank 41. Then, the lifter 42 lowers the plurality of substrates W to the processing position, and immerses the plurality of substrates W in the processing tank 41 (step S151: an immersion step). In this way, the coarse rinse processing is substantially started. Initially, since the temperature of the first rinse liquid is relatively high, the rapid cooling on the substrates W can be suppressed, and the damage to the substrates W can be suppressed.

For example, when a predetermined period of time has elapsed from step S151, the coarse rinse processing unit 40 reduces the temperature of the first rinse liquid to a second temperature (for example, 25°C) (step S152: a temperature reduction step). Specifically, the valve 433 is opened in a state where the heater 434 stops operating. In this way, the first rinse liquid at a lower temperature is supplied from the nozzle 431 to the processing tank 41, and the first rinse liquid overflowing from the upper portion of the processing tank 41 is discharged from the outside through the upflow tank 411 and the liquid discharge pipe 442. In this way, the temperature of the first rinse liquid inside the processing tank 41 decreases.

Then, as a prescribed processing period of time has elapsed from step S151, the lifter 42 raises the plurality of substrates W from the processing position to the delivery position (step S153: a pulling-up step).

As described above, in the examples described above, the temperature of the first rinse liquid decreases during the coarse rinse processing. Accordingly, it is possible to reduce a replacement speed from the phosphoric acid to the first rinse liquid while suppressing the damage to the substrates W due to the rapid cooling. Therefore, it is possible to suppress reduction of the concentration of the phosphoric acid in the patterns more than necessary.

### <Rising Speed>

Next, a first rising speed when the lifter 32 of the phosphoric acid processing unit 30 pulls up the plurality of substrates W from the processing tank 31 and a second rising speed when the lifter 42 of the coarse rinse processing unit 40 pulls up the plurality of substrates W from the processing tank 41, will be described. Note that the first rising speed referred to herein is, for example, a maximum value (or a steady value or a target value) of the rising speed of the substrates W by the lifter 32, and the second rising speed is, for example, a maximum value (or a steady value or a target value) of the rising speed of the plurality of substrates W by the lifter 42. The second rising speed is preferably equal to or less than the first rising speed. For example, the first rising speed is set to 25 mm/sec or more, and the second rising speed is set to 25 mm/sec or less.

In this case, the plurality of substrates W are pulled up from the first rinse liquid inside the processing tank 41 at a low rising speed. In this way, in particular, it is possible to reduce an amount of the liquid (mainly the first rinse liquid) adhering to the out-of-pattern region of the each of the substrates W.

In this way, it is possible to suppress adhesion of the liquid to the transfer unit 22, the carrier C2, the indexer robot 52, and the transfer robot 53 by holding the substrates W subjected to the coarse rinse processing.

### <Second Embodiment>

The substrate processing apparatus 10 according to the second embodiment is similar to the substrate processing apparatus 10 according to the first embodiment except for the example of the configuration of the coarse rinse processing unit 40. The coarse rinse processing unit 40 according to the second embodiment is hereinafter also referred to as a coarse rinse processing unit 40A.

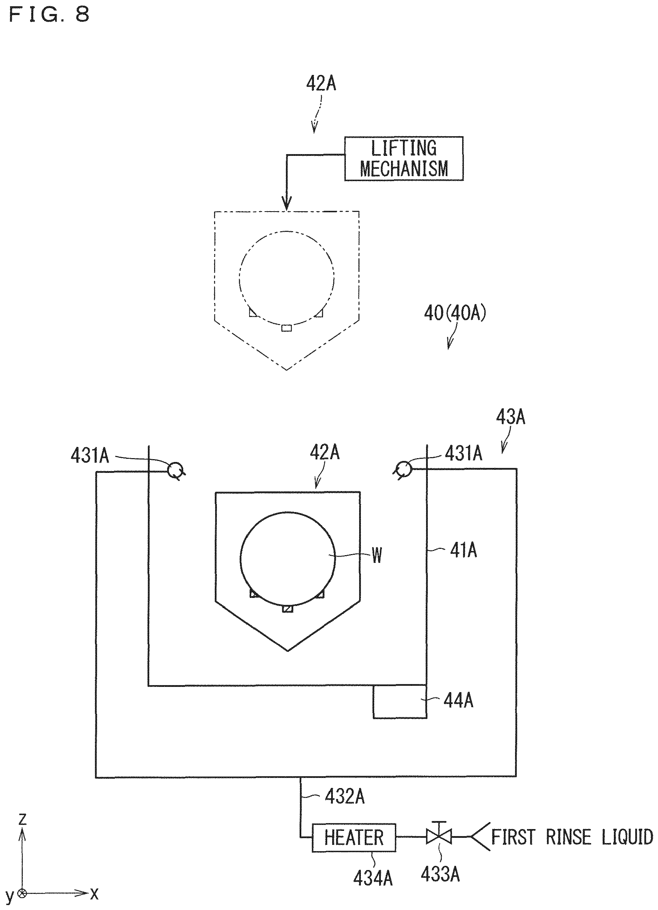

Fig. 8 shows a diagram schematically showing an example of a configuration of the coarse rinse processing unit 40A. The coarse rinse processing unit 40A includes a vat 41A, a lifter 42A, a rinse liquid supply unit 43A, and a discharge unit 44A.

The vat 41A has a box shape, and an internal space of the bat corresponds to a processing space for processing the plurality of substrates W. A vat 41B can also be said to be a processing space forming member (or a chamber) for forming the processing space.

The lifter 42A has a similar structure to the lifter 42, and raises and lowers the plurality of substrates W between the delivery position and the processing position. The delivery position is a position vertically above the vat 41A, and is a position where the plurality of substrates W are received from and delivered to the transfer unit 22. The processing position is a position where the plurality of substrates W are housed in the processing space.

The rinse liquid supply unit 43A supplies the first rinse liquid to the plurality of substrates W located in the processing space. The rinse liquid supply unit 43A includes nozzles 431A, a liquid supply pipe 432A, and a valve 433A. The nozzles 431A are disposed in the vat 41A, and discharges the first rinse liquid to the plurality of substrates W located in the processing space. The nozzles 431A may be nozzles that discharge the first rinse liquid in a liquid columnar state to the plurality of substrates W, may be shower nozzles that discharge the first rinse liquid in a shower state to the plurality of substrates W, or may be mist nozzles that discharge the first rinse liquid in a mist state to the plurality of substrates W.

In the example of Fig. 8, the nozzles 431A are disposed vertically above the plurality of substrates W located at the processing position. Further, in the example of Fig. 8, a pair of the nozzles 431A are disposed. Each of the nozzles 431A are disposed on opposite sides to each other with respect to the substrates W in the horizontal direction (a left-right direction in Fig. 8) parallel to the main surfaces of the substrates W. In other words, one nozzle 431A is disposed on one side with respect to the substrates W, and the other nozzle 431A is disposed on the other side with respect to the substrates W. Further, on each of both sides with respect to the substrates W, a plurality of the nozzles 431A may be arranged side by side in the thickness direction of the substrates W (the direction perpendicular to the paper surface of Fig. 8).

The nozzles 431A are connected to the rinse liquid supply source through the liquid supply pipe 432A. The valve 433A is interposed in the liquid supply pipe 432A. Since the valve 433A is opened, the first rinse liquid is supplied from the rinse liquid supply source to the nozzles 431A through the liquid supply pipe 432A, and discharged from discharge ports of the nozzles 431A toward the plurality of substrates W. In this way, the first rinse liquid is supplied to the plurality of substrates W.

The first rinse liquid flows down along both main surfaces (that is, the front surface and the back surface) of the each of the substrates W. The liquid flowing down from the each of the substrates W is discharged to the outside through the discharge unit 44A connected to a bottom portion of the vat 41A. The discharge unit 44A includes a discharge pipe and a valve, all of which are not shown.

In the example of Fig. 8, a heater 434A is disposed in the liquid supply pipe 432A. The heater 434A heats the first rinse liquid. In this way, the first rinse liquid heated is discharged from the nozzles 431A. The heater 434A heats the first rinse liquid discharged from the nozzles 431A such that the temperature of the first rinse liquid is higher than the normal temperature and lower than the temperature of the phosphoric acid in the phosphoric acid processing, for example, about 60°C. In this way, the rapid cooling on the substrates W by the first rinse liquid can be suppressed, and the damage to the substrates W can be alleviated.

When the nozzles 431A supply the first rinse liquid to the plurality of the substrates W, the first rinse liquid flows down along both the main surfaces of the each of the substrates W, and thus the phosphoric acid adhering to both the main surfaces of the substrates W is gradually replaced with the first rinse liquid over time from start of supply. In other words, the coarse rinse processing is performed.

Also in the second embodiment, the coarse rinse processing ends when the phosphoric acid remains sufficiently in the patterns of the substrates W. Specifically, the rinse liquid supply unit 43A ends discharge of the first rinse liquid from the nozzles 431A when a prescribed processing period of time has elapsed from a point of time when the nozzles 431A has started the discharge of the first rinse liquid. The processing period of time is a period of time for which the phosphoric acid sufficiently remains inside the patterns, and is set to, for example, about 1 minute to 2 minutes.

As described above, in the second embodiment, the coarse rinse processing is performed by discharging the first rinse liquid toward the plurality of substrates W.

Note that, as in the first embodiment, the coarse rinse processing unit 40A may reduce the temperature of the first rinse liquid during the coarse rinse processing. For example, the heater 434A may reduce a calorific value during the coarse rinse processing, or may end the operations.

### <Third Embodiment>

The substrate processing apparatus 10 according to the third embodiment is similar to the substrate processing apparatus 10 according to the first embodiment except for the example of the configuration of the coarse rinse processing unit 40. Hereinafter, the coarse rinse processing unit 40 according to the third embodiment is also referred to as coarse rinse processing unit 40B.

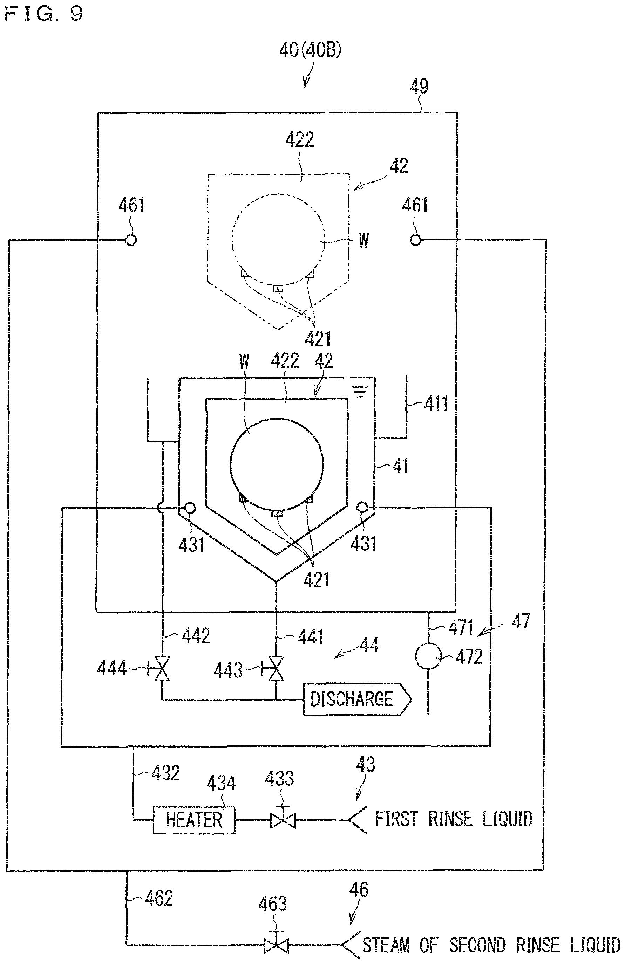

Fig. 9 shows an example of a configuration of the coarse rinse processing unit 40B. As compared with the coarse rinse processing unit 40 according to the first embodiment, the coarse rinse processing unit 40B further includes a steam supply unit 46. The steam supply unit 46 supplies the steam of the second rinse liquid into the chamber 49. The second rinse liquid is a liquid having latent heat of vaporization lower than the latent heat of vaporization of the first rinse liquid, and is, for example, an organic solvent, more specifically, isopropyl alcohol.

The steam supply unit 46 includes nozzles 461, a gas supply pipe 462, and a valve 463. The nozzles 461 are disposed vertically above the upper end of the processing tank 41 in the chamber 49. In the example of Fig. 9, a pair of nozzles 461 are disposed. Two nozzles 461 are spaced apart from each other in the horizontal direction parallel to the main surfaces of the substrates W.

The gas supply pipe 462 connects the nozzles 461 and the steam supply source. The valve 463 is interposed in the gas supply pipe 462. Since the valve 463 is opened, the steam of the second rinse liquid is supplied from the steam supply source to the nozzles 461 through the gas supply pipe 462, and discharged from discharge ports of the nozzles 461 to an upper space (that is, a space vertically above the processing tank 41) of the chamber 49.

In the example of Fig. 9, a gas discharge unit 47 is disposed in the chamber 49. The gas discharge unit 37 discharges a gas in the chamber 49. In the example of Fig. 9, the gas discharge unit 47 includes a gas discharge pipe 471 and a suction mechanism 472. An upstream end of the gas discharge pipe 471 is connected to, for example, a bottom portion of the chamber 49. The suction mechanism 472 is disposed in the gas discharge pipe 471, and sucks the gas in the chamber 49 through the gas discharge pipe 471. The suction mechanism 472 is, for example, a pump.

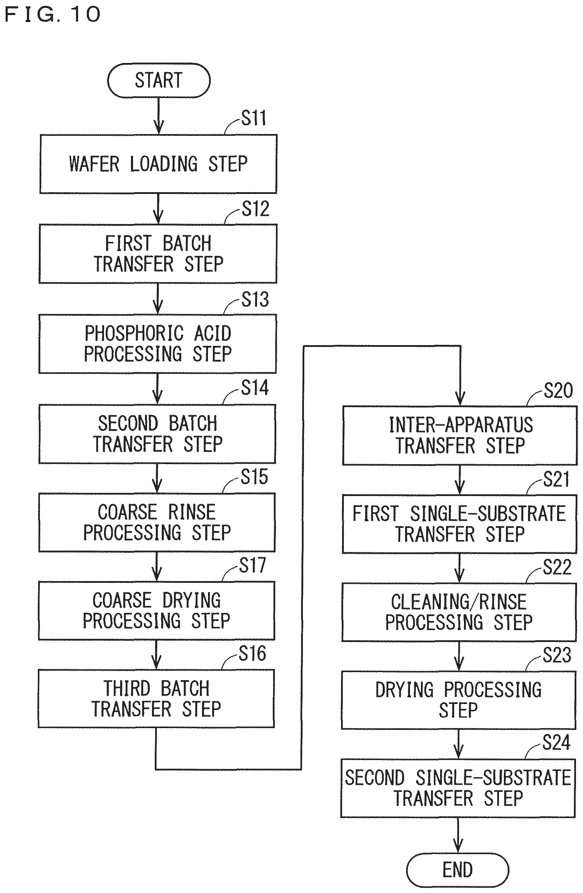

Fig. 10 shows a flowchart showing an example of operations of the substrate processing apparatus 10 according to the third embodiment. In the third embodiment, as compared with the first embodiment, the coarse drying processing (step S17: the coarse drying processing step) is further executed after the coarse rinse processing (step S15).

The coarse drying processing is processing for removing at least a part of the liquid adhering to the out-of-pattern region of the each of the substrates W. In other words, in the coarse drying processing, the phosphoric acid in the patterns of the substrates W is not removed, but the liquid adhering to the out-of-pattern regions is mainly reduced.

As a specific example, the coarse rinse processing unit 40B exposes the plurality of substrates W subjected to the coarse rinse processing to an atmosphere of the steam of the second rinse liquid. First, the steam supply unit 46 supplies the steam of the second rinse liquid to the upper space in the chamber 49. In this way, the upper space can have the atmosphere of the steam of the second rinse liquid. Note that the steam supply unit 46 may start supply of the steam of the second rinse liquid before start of the coarse drying processing. More specifically, the steam supply unit 46 may start the supply of the steam of the second rinse liquid before or during start of the coarse rinse processing (step S15). In this way, during the coarse rinse processing, the atmosphere of the steam of the second rinse liquid can be formed in an upper space above the processing tank 41.

Then, as the lifter 42 raises the plurality of substrates W into the upper space, the plurality of substrates W can be exposed to the atmosphere of the steam of the second rinse liquid. In this way, the coarse drying processing is substantially started.

Since the steam of the second rinse liquid acts on the out-of-pattern regions of the substrates W, the liquid (mainly the first rinse liquid) adhering to the out-of-pattern regions is replaced with the second rinse liquid, and the liquid flows down from the substrates W and is removed from the substrates W. Further, since the second rinse liquid is easily evaporated, the out-of-pattern regions can be more effectively dried. On the other hand, since the phosphoric acid inside the patterns is less likely to be replaced with the second rinse liquid due to the action of the steam of the second rinse liquid, the phosphoric acid in second patterns can remain. Accordingly, it is possible to suppress or avoid the pattern collapse of the substrates W subjected to the coarse drying processing.

Then, for example, as a preset period of time has elapsed from start of step S 17, the steam supply unit 46 ends the supply of the steam of the second rinse liquid. Then, the lid of the chamber 49 is opened, and the lifter 42 raises the plurality of substrates W to the delivery position.

Note that before the lid of the chamber 49 is opened, the steam of the second rinse liquid in the chamber 49 may be discharged by the gas discharge unit 47. In a case where the coarse rinse processing unit 40B includes a nitrogen gas supply unit that supplies a nitrogen gas into the chamber 49, the nitrogen gas may be supplied into the chamber 49. In this way, the steam of the second rinse liquid can be effectively discharged from the chamber 49.

Next, as in the first embodiment, the processes subsequent to the third batch transfer step (step S16) are executed.

As described above, in the third embodiment, the coarse drying processing is performed. In the coarse drying processing, at least a part of the liquid adhering to the out-of-pattern regions of the substrates W is removed while the phosphoric acid in the patterns remains. Therefore, even when each of the transfer unit 22, the carrier C2, the indexer robot 52, and the transfer robot 53 holds the substrate W, it is possible to suppress adhesion of the liquid to the carrier C2 and the transfer apparatus. Accordingly, it is possible to suppress contamination of the carrier C2 and the transfer apparatus due to the liquid.

### <Fourth Embodiment>

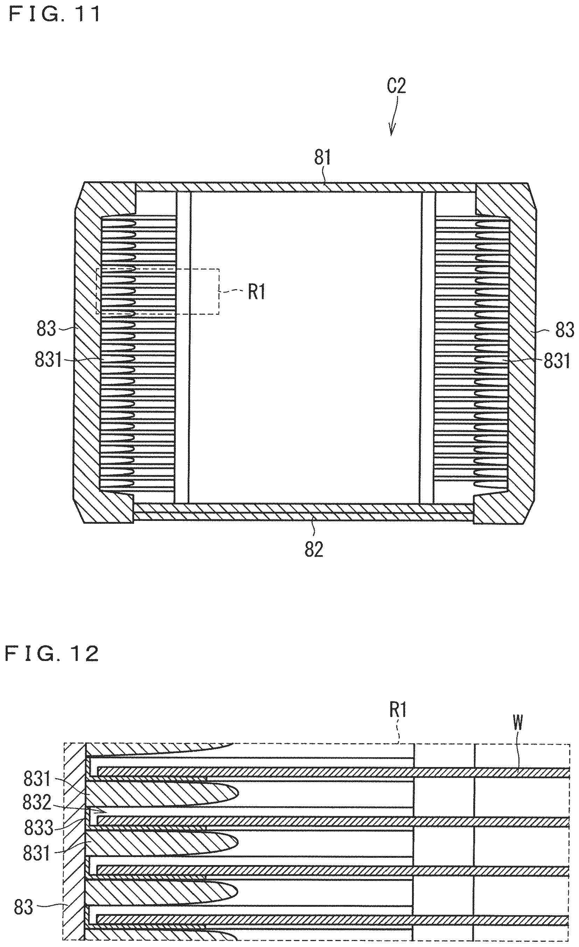

In the fourth embodiment, the carrier C2 will be described. Figs. 11 and 12 are diagrams schematically showing an example of a configuration of the carrier C2 according to the fourth embodiment. Fig. 11 shows a front view of the carrier C2, and Fig. 12 shows an enlarged view of a region R1 in Fig. 11.

The carrier C2 includes an upper member 81, a lower member 82, and side walls 83. The upper member 81 and the lower member 82 have, for example, a plate shape, and are disposed in a form in which thickness directions of the members are along the vertical direction. The upper member 81 and the lower member 82 are disposed to face each other in the vertical direction. The side walls 83 are member that connect peripheral edges of the upper member 81 and the lower member 82. The side walls 83 are not disposed on one surface (a front side in the paper surface) of the carrier C2 and opened. The substrates W are taken in and out of the carrier C2 through the opening of the carrier C2.

As shown in Fig. 11, a plurality of protrusions 831 are disposed on inner wall surfaces of the side walls 83 at intervals in the vertical direction. Each of the protrusions 831 protrudes inward from the side walls 83. Accordingly, a plurality of grooves 832 are formed in the inner wall surfaces of the side walls 83. Each of the grooves 832 corresponds to a space between two adjacent protrusions 831. The end portions of the substrates W are inserted into the corresponding grooves 832 and supported by the protrusions 831. Fig. 12 shows the region R1 in which the substrate W are housed in the carrier C2.

In the example of Fig. 12, a water-absorbing member 833 is disposed on a lower surface (that is, an upper surface of the protrusion 831) and a side surface of the groove 832. The water-absorbing member 833 is a water-absorptive member, and is made of, for example, a water absorptive material such as nonwoven fabric or diatomaceous earth.

A part of a portion of the water-absorbing member 833 disposed on the lower surface of the groove 832 is in contact with a lower surface of the substrate W to support the substrate W. In other words, the water-absorbing member 833 is in contact with a part of the out-of-pattern region of the each of the substrates W. Accordingly, the liquid adhering to the lower surface of the substrate W is absorbed by the water-absorbing member 833. Further, a part of a portion of the water-absorbing member 833 disposed on the side surface of the groove 832 can be in contact with a side surface of the substrate W. In this case, the liquid adhering to the side surface of the substrate W is also absorbed by the water-absorbing member 833.

For comparison, a structure in which the water-absorbing member 833 is not disposed will be considered. In this case, the liquid adhering to the lower surface of the substrate W can be transferred to the protrusion 831, travel to the upper surface and an inner peripheral edge of the protrusion 831, and fall down to the next one substrate W below. In this way, the next one substrate W below may be contaminated.

In contrast, in the fourth embodiment, since the water-absorbing member 833 is disposed, it is possible to suppress or avoid movement of the liquid through the protrusions 831. Accordingly, it is possible to suppress or avoid contamination of the substrate W.

Then, as shown in Fig. 12, in a case where the water-absorbing member 833 is also disposed on the side surface of the groove 832, the liquid at a peripheral edge portion of the front surface of the substrate W can also move toward the water-absorbing member 833 side due to surface tension to be absorbed by the water-absorbing member 833 when the liquid attached to the side surface of the substrate W is absorbed by the water-absorbing member 833. Accordingly, the liquid at the peripheral edge portion of the front surface of the substrate W can also be reduced.

On the other hand, with the water-absorbing member 833, the phosphoric acid in the pattern on the front surface of the substrate W can move to a peripheral edge side of the substrate W due to a capillary phenomenon to be absorbed by the water-absorbing member 833. This is undesirable because of the pattern collapse.

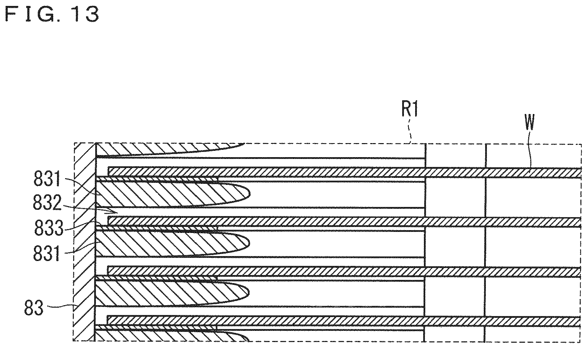

Fig. 13 shows a diagram schematically showing an example of another configuration of the carrier C2, and shows an enlarged view of the region R1 in Fig. 11. In the example of Fig. 13, the water-absorbing member 833 is disposed to bypass the side surface of the groove 832. In other words, the water-absorbing member 833 is not disposed on the entire side surface of groove 832, and the water-absorbing member 833 is disposed only on the lower surface of groove 832. In this way, it is possible to more reliably suppress absorption of the phosphoric acid in the pattern of the substrate W by the water-absorbing member 833. In addition, it is possible to more reliably suppress the pattern collapse.

As described above, the substrate processing apparatus 10 and the substrate processing method have been described in detail, but the above description is exemplary in all aspects, and the substrate processing apparatus 10 and the substrate processing method are not limited thereto. It is understood that numerous modifications not exemplified can be assumed without departing from the scope of the present disclosure. Each of the configurations described in a respective one of the embodiments described above and a respective one of the modifications can be appropriately combined or omitted unless there is a contradiction between each other.

For example, in the examples described above, in the substrate processing apparatus 10, the batch-type phosphoric acid processing unit 30 and the coarse rinse processing unit 40 are disposed in the housing 29, and the single-substrate type single-substrate processing unit 60 is disposed in the housing 59 different from the housing 29. Then, the inter-apparatus transfer unit 70 transfers the carrier C2 between the housing 29 and the housing 59. However, the present invention is not necessarily limited thereto. The batch-type phosphoric acid processing unit 30, the coarse rinse processing unit 40, and the single-substrate type single-substrate processing unit 60 may be disposed in a common housing. In the housing, a transfer unit that transfers the substrates W between the coarse rinse processing unit 40 and the single-substrate processing unit 60 is disposed, and a form changing unit (for example, the form changing unit 24) is disposed in the transfer unit. The substrate processing apparatus 10 can also be referred to as a hybridtype processing apparatus. In the apparatus, the batch-type phosphoric acid processing unit 30, the coarse rinse processing unit 40, and the single-substrate type single-substrate processing unit 60 are disposed in such single housing.

Further, in the examples, the laminated structure 90 is disposed as the three-dimensional structure (the pattern) on the substrate W, but the present invention is not necessarily limited thereto. The three-dimensional structure includes at least one of a wiring pattern, an insulating film pattern, and a semiconductor pattern. For example, when an aspect ratio of the pattern is 10 or more and a width of the pattern is 50 nm or less, the pattern collapse is likely to occur. Accordingly, in this case, the substrate processing apparatus 10 is particularly effective.

### EXPLANATION OF REFERENCE SIGNS

10: substrate processing apparatus
24: form changing unit
30: phosphoric acid processing unit
31: processing tank
40: coarse rinse processing unit
50: single-substrate processing apparatus (second processing apparatus)
51: load port
60: single-substrate processing unit
833: water-absorbing member
S13: phosphoric acid processing step (step)
S15: coarse rinse processing step (step)
S152: temperature reduction step (step)
S 16: first step (step)
S17: coarse drying processing step (step)
S20: second step (step)
S21: third step (step)
S23: single-substrate drying processing step (step)
S24: fourth step (step)
C2: first carrier (carrier)
C3: second carrier (carrier)
W: substrate

## Claims

1. A substrate processing method comprising:
a phosphoric acid processing step of immersing a plurality of substrates in phosphoric acid inside a processing tank;
a coarse rinse processing step of replacing a part of said phosphoric acid adhering to said plurality of substrates with a first rinse liquid to an extent that said phosphoric acid remains in patterns of said plurality of substrates after said phosphoric acid processing step; and
a single-substrate drying processing step of drying said plurality of substrates one by one after said coarse rinse processing step.

2. The substrate processing method according to claim 1, wherein said coarse rinse processing step ends in a state where a concentration of said phosphoric acid in said patterns is 50% or more.

3. The substrate processing method according to claim 1 or 2, wherein said coarse rinse processing step includes a temperature reduction step of reducing a temperature of said first rinse liquid.

4. The substrate processing method according to any one of claims 1 to 3, the method further comprising a coarse drying processing step of removing at least a part of a liquid adhering to out-of-pattern regions of said plurality of substrates without said patterns formed thereon between said coarse rinse processing step and said single-substrate drying processing step.

5. The substrate processing method according to claim 4, wherein in said coarse drying processing step, said plurality of substrates are exposed to an atmosphere of steam of a second rinse liquid having latent heat of vaporization lower than that of said first rinse liquid.

6. The substrate processing method according to any one of claims 1 to 5, wherein
said phosphoric acid processing step includes:
a step of lowering said plurality of substrates to immerse said plurality of substrates in said phosphoric acid inside said processing tank; and
a step of raising said plurality of substrates at a first rising speed to pull up said plurality of substrates from said processing tank, and
said coarse rinse processing step includes:
a step of lowering said plurality of substrates to immerse said plurality of substrates in said first rinse liquid; and
a step of raising said plurality of substrates at a second rising speed lower than or equal to said first rising speed to pull up said plurality of substrates from said first rinse liquid.

7. The substrate processing method according to any one of claims 1 to 6, the method further comprising:
a first step of transferring said plurality of substrates to a first carrier after said coarse rinse processing step;
a second step of transferring said first carrier to a load port of a single-substrate type processing apparatus after said first step;
a third step of transferring said plurality of substrates one by one from said first carrier of said load port to a single-substrate processing unit between said second step and said single-substrate drying processing step; and
a fourth step of transferring the substrates from said single-substrate processing unit to a second carrier of said load port after said single-substrate drying processing step.

8. The substrate processing method according to claim 7, wherein said first carrier includes a water-absorbing member that is partially in contact with an out-of-pattern region of each of said plurality of substrates without said pattern formed thereon.

9. A substrate processing apparatus comprising:
a phosphoric acid processing unit that has a processing tank and immerses a plurality of substrates in phosphoric acid inside said processing tank;
a coarse rinse processing unit that replaces a part of said phosphoric acid adhering to said plurality of substrates with a rinse liquid to an extent that said phosphoric acid remains in patterns of said plurality of substrates; and
a single-substrate processing unit that dries said plurality of substrates one by one.

10. The substrate processing apparatus according to claim 9, further comprising a form changing unit that changes forms of said plurality of substrates between a horizontal form and an upright form,
wherein
said phosphoric acid processing unit immerses said plurality of substrates in the upright form in said phosphoric acid inside said processing tank, and
said single-substrate processing unit performs drying processing on each of the substrates in the horizontal form.
